Europäisches Patentamt

European Patent Office

Office européen des brevets

(19)

(11) Veröffentlichungsnummer: **0 334 111**
A1

## (12) EUROPÄISCHE PATENTANMELDUNG

(21) Anmeldenummer: 89104131.1

(22) Anmeldetag: 08.03.89

(51) Int. Cl.⁴: **H01L 27/14** , **H01L 25/08**

(30) Priorität: 24.03.88 DE 3810026

(43) Veröffentlichungstag der Anmeldung:
27.09.89 Patentblatt 89/39

(84) Benannte Vertragsstaaten:
DE FR GB IT

(71) Anmelder: **Siemens Aktiengesellschaft**
**Wittelsbacherplatz 2**
**D-8000 München 2(DE)**

(72) Erfinder: **Plättner, Rolf, Dr.**
**Hochackerstrasse 28c**
**D-8012 Riemerling(DE)**

(54) **Verfahren zur integrierten Serienverschaltung von Dickschichtsolarzellen sowie Verwendung dieses Verfahrens bei der Herstellung einer Tandem-Solarzelle.**

(57) Zur Serienverschaltung einer Vielzahl von Dickschichtsolarzellen werden die Trenngräben (5) in der Dickschicht (4) zum Anbringen der leitenden Verbindungen zwischen den Zellen mittels der Abhebetechnik (lift-off- Technik) dadurch erzeugt, daß das für die Abhebetechnik notwendige Streifenmuster (3) als Paste im Siebdruckverfahren vor der ganzflächigen Abscheidung der Dickschicht (4) auf das mit der strukturierten Grundelektrode (2) versehene Substrat (1) aufgebracht und vor dem Abscheiden der Deckelektrodenschicht (6) wieder entfernt wird. Auf diese Weise können umständliche mechanische Trennverfahren umgangen werden. Gemäß einem Ausführungsbeispiel nach der Erfindung ist vorgesehen, als Dickschicht (4) eine polykristalline Siliziumschicht zu verwenden und die damit hergestellte Solarzelle (II) über einen optischen Koppler (III) mit einer Solarzelle (I) auf der Basis von amorphem hydrogenisiertem Silizium (a-Si:H) zu kombinieren, wobei die a-Si:H-Zelle (I) mit zwei transparenten Elektroden als Frontzelle geschaltet ist. Das Verfahren ist kostengünstig, da es gut automatisierbar ist und einen hohen Durchsatz erlaubt.

FIG 7

FIG 6

## Verfahren zur integrierten Serienverschaltung von Dickschichtsolarzellen sowie Verwendung dieses Verfahrens bei der Herstellung einer Tandem-Solarzelle.

Die Erfindung betrifft ein Verfahren zur integrierten Serienverschaltung einer Vielzahl von auf einem isolierenden transparenten Substrat angeordneten Dickschichtsolarzellen.

Solarzellen aus kristallinem Silizium müssen aufgrund des relativ hohen erzeugten Stroms von etwa 40 mA/cm² in Form von kleinen Flächen von etwa 1 dm² miteinander verschaltet werden, um Stromverluste zu vermeiden. Das gilt für die Kristallscheiben des einkristallinen Siliziums, deren Größen durch das Kristallzüchtungsverfahren begrenzt sind.

Auch größere Flächen aus polykristallinem Silizium, die zum Beispiel bei Bandziehverfahren erreichbar sind, müssen deshalb in etwa 10 cm x 10 cm große Scheiben gesägt und anschließend mit Metallbändchen wieder reihenförmig verlötet werden. Stromverluste können so zwar ausreichend vermieden werden, der Prozeß ist aber aufwendig und teuer.

Ein weiterer Nachteil des kristallinen Siliziums ist, daß der niedrige Bandabstand von $E_g = 1,1$ eV dem Sonnenspektrum mit seinem Intensitätsmaximum bei 1,45 eV nur schlecht angepaßt ist. Es wäre daher wünschenswert, wenn dieser niedrige Bandabstand mit einem ausreichend oberhalb von 1,45 eV liegenden Bandabstand in einer Tandemzelle kombiniert werden könnte.

Eine solche Möglichkeit ist zum Beispiel durch Kombination von polykristallinem Silizium ($E_g$ 1,1 eV) mit amorphem Silizium ($E_g$ 1,75 eV) gegeben. In beiden Teilzellen könnte als Halbleitermaterial Silizium verwendet werden, ein Material, welches weder mit Ressourcen-, noch mit Umweltproblemen behaftet ist.

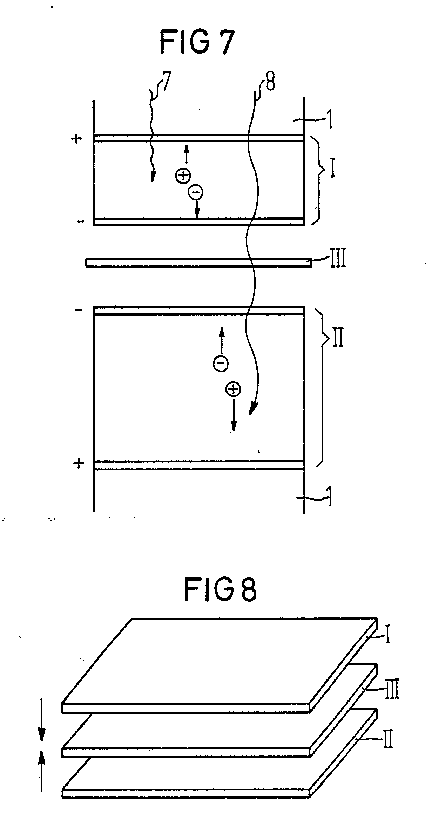

Der an sich bekannte Aufbau und die Funktion der Tandemzelle ist in Figur 7 dargestellt. Amorphes Silizium im Form von hydrogeniertem a-Si:H hat einen Bandabstand von typisch 1,75 eV, der sich durch Variation der Herstellungsbedingungen noch etwas verschieben läßt (1,7 bis 1,8 eV). Solarzellen aus amorphem Silizium gibt es bereits, auch in der für Frontzellen notwendigen Ausführungsform mit zwei transparenten Elektroden, wie aus einem Bericht von D. Morel et al. in den Proceedings of the 18th Photovoltaic Specialists Conference 1985 auf den Seiten 876 bis 882 zu entnehmen ist.

Das Silizium hat in den a-Si:H-Solarzellen nur eine Schichtdicke von weniger als 0,5 μm. Durch Zusatz von Kohlenstoff kann der Bandabstand des amorphen Siliziums in diesen Zellen sogar noch etwas erhöht werden. Die für die untere Teilzelle notwendige Schichtdicke des polykristallinen Siliziums liegt dagegen bei 20 bis 30 μm (Dickschichtzelle). Das Sonnenlicht wird dann bereits ausreichend absorbiert. In Figur 7 gelten folgende Bezugszeichen:

I = obere Solarzelle aus amorphem hydrogeniertem Silizium mit einem Bandabstand $E_{g1}$

II = untere Solarzelle aus polykristallinem Silizium mit einem Bandabstand $E_{g2}$ ($E_{g1}$ größer $E_{g2}$)

III = optischer Koppler

1 = Glassubstrat

Der Pfeil 7 gilt für die Eindringtiefe des kurzwelligen Lichtes, der Pfeil 8 für die Eindringtiefe des langwelligen Lichtes.

Die aus Kostengründen zu bevorzugende Technologie zur Herstellung der polykristallinen Siliziumdickschichten ist eine Technik analog der Dünnfilmtechnik. Entscheidend ist dabei, daß diese Teilzellen ohne aufwendige mechanische Nachbearbeitung mit genügend glatter Oberfläche hergestellt werden können, so daß sie anschließend durch einen einfachen Laminierprozeß mit den a-Si:H-Zellen verbunden werden können (Figur 8). Ein wesentlicher Vorteil der Dünnfilm-Solarzellen ist es, daß sie durch Trennung in schmale Streifen serienverschaltet werden können, so daß Module mit höherer Spannung und geringem Strom entstehen.

Die Serienverschaltung der Dickschichtzellen in kleinen Flächeneinheiten (Streifenzellen) ist ebenfalls wünschenswert, um auch in diesem Teil der Tandem-Solarzelle mit geringen Stromverlusten auszukommen und die Spannung der Module nach äußeren Notwendigkeiten einstellbar zu machen. Dies ist bisher nicht kostengünstig möglich.

Aus der europäischen Patentanmeldung 0 232 749 A2 ist ein Verfahren für Dünnschichtsolarzellen bekannt, bei dem zur Verschaltung Trenngräben in der, auf dem mit den Frontelektroden versehenen Substrat aufgebrachten Dünnschicht dadurch erzeugt werden, daß vor dem Aufbringen der Metallelektrodenschicht mit den metallischen Verbindungen ein Streifenmuster aus vorzugsweise Kunststoff aufgebracht wird, dann neben dem Streifenmuster die Trenngräben auf mechanischem Wege erzeugt werden, dann die Trenngräben mit Metall aufgefüllt und die Metallelektrodenschicht niedergeschlagen wird, und anschließend durch Abhebetechnik das Streifenmuster wieder entfernt wird, wobei die Metallelektrodenstruktur gebildet wird.

Ein weiteres, auf mechanische Trennung beruhendes Verfahren zur Herstellung von serienverschalteten Modulen aus kristallinem Silizium ist in der deutschen Patentanmeldung P 37 27 825.8 vorgeschlagen worden. Bei diesem Verfahren werden schmale, bereits auf dem Substrat vorgesehene Stege, die durch Herausarbeiten von Material aus dem Glassubstrat entstehen, für die Trennung der streifenförmigen Einzelsolarzellen verwendet. Die im Siebdruckverfahren erzeugten Front-Elektroden stellen dann die Serienverschaltung über Kontaktgräben her.

Beide bekannte Verfahren, insbesondere das letztere - bedingt durch das Mitbeschichten der Stege - haben den' großen Nachteil, daß aufwendige Wasch- und Schleifprozesse durchgeführt werden müssen. Außerdem muß die beim Schleifen entstehende defektrei che damage-Schicht in einem zusätzlichen Ätzprozeß beseitigt werden. Dieses Verfahren bringt außer höheren Kosten auch Schwierigkeiten in Form von Randausbrüchen in der Schicht durch den Schleifprozeß mit sich. Insgesamt sind solche Prozesse an die Dünnschicht-Technologie nicht angepaßt.

Aufgabe der Erfindung ist es daher, eine an die Dünnschichttechnik angepaßte Prozeßfolge für Dickschichtsolarzellen anzugeben, die diese Nachteile nicht aufweist und durch die es auf einfache Weise möglich ist, insbesondere aus polykristallinem Silizium bestehende Teilzellen herzustellen und in der Weiterverarbeitung zu Tandem-Solarzellen mit Zellen aus amorphem hydrogenisiertem Silizium zu kombinieren.

Die Erfindung wird durch ein Verfahren der eingangs genannten Art gelöst, welches durch folgende Merkmale gekennzeichnet ist:

a) ein Streifenmuster wird vor der Abscheidung der Dickschicht als Paste im Siebdruckverfahren auf die strukturierte Grundelektrode so aufgebracht, daß es den in Richtung zur benachbarten, für die Verschaltung vorgesehenen Zelle liegenden Elektrodenrand bedeckt,

b) dann wird die Dickschicht ganzflächig abgeschieden,

c) das Streifenmuster wird durch Abhebetechnik entfernt, wobei die selektive Trennung der Dickschicht erfolgt und

d) die Deckelektrode wird ganzflächig aufgebracht und strukturiert.

Es liegt im Rahmen der Erfindung, daß eine Dickschicht aus polykristallinem Silizium verwendet wird. Die Schichtherstellung kann nach verschiedenen Verfahren, wie zum Beispiel durch Abscheidung aus der Gasphase nach thermischer Zersetzung einer Silizium enthaltenden gasförmigen Verbindung, Abscheidung im Glimmentladungsplasma, Aufdampfen oder Kathodenzerstäubung (Sputtern) großflächig erfolgen.

Weitere Ausgestaltungen der Erfindung ergeben sich aus den Unteransprüchen.

Nachfolgend wird anhand von Ausführungsbeispielen und der Figuren 1 bis 8 die Erfindung noch näher erläutert. Dabei zeigen

die Figuren 1 bis 5 in Perspektive den Prozeßablauf zur Herstellung einer Solarzellenanordnung nach der Erfindung,

die Figur 6 den wesentlichen Ausschnitt nach Figur 5,

die Figur 7 den Aufbau und die Funktion von Tandemzellen, die durch die Erfindung ermöglicht werden und

die Figur 8 in Perspektive ein Prinzipbild einer Tandemzelle gemäß Figur 7.

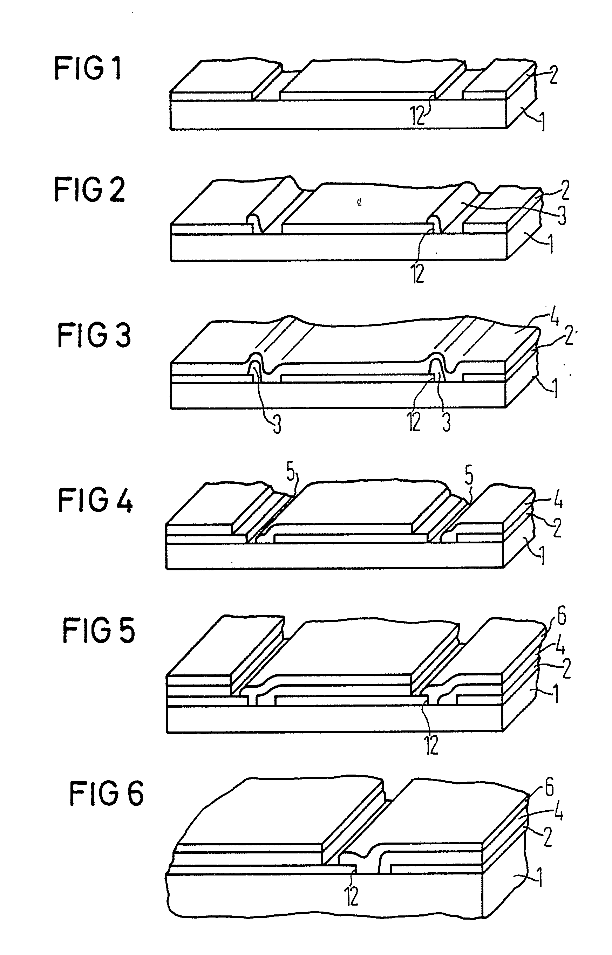

Figur 1: Bei dem hier beschriebenen Ausführungsbeispiel wird die Solarzelle von der Metallelektrodenseite ausgehend aufgebaut; es ist analog auch möglich, den Aufbau in umgekehrter Reihenfolge von der transparenten Elektrodenseite ausgehend vorzunehmen.

Dazu wird auf ein aus Glas bestehendes Substrat 1 großflächig eine aus Metall (zum Beispiel Aluminium) bestehende Schicht aufgebracht und durch ein Siebdruckverfahren in bekannter Weise so strukturiert, daß die Elektrodenstruktur 2, 12 entsteht.

Figur 2: Auf diese Anordnung werden mittels einer Paste aus zum Beispiel Plexigum mit einem Füllstoff aus zum Beispiel Kalkpulver ein Streifenmuster von Linien 3 im Siebdruckverfahren so aufgebracht, daß sie den in Richtung zur benachbarten, für die Verschaltung vorgesehenen Zelle liegenden Rand 12 der Elektrodenschicht 2 bedekken. Das Füllmaterial in der Siebdruckpaste soll porös und deshalb aus relativ grobkörnigem Material aufgebaut sein, so daß beim späteren Ablösen der Streifen die Badflüssigkeit leicht in die Streifen eindringen kann.

Figur 3: Nach Trocknung der Pastenlinien 3 wird darauf ganzflächig eine polykristalline Siliziumschicht 4 durch Abscheidung aus der Gasphase oder durch Sputtern aufgebracht. Als besonders geeignet erscheint das Plasma-CVD( = chemical vapor deposition)-Verfahren der Zersetzung von gasförmigen Siliziumverbindungen, wie zum Beispiel von Silan. Wichtig ist, daß der Prozeß für die Herstellung der polykristallinen Siliziumschicht mit Prozeßtemperaturen unterhalb der Erweichungstemperatur des Substratglases auskommt. Für einen hohen Wirkungsgrad der Solarzellen ist es notwendig, daß die Kristallite eine Große im Millimeter-Bereich haben. Durch das Plasmaabscheideverfahren treten hohe Anregungsenergien der Siliziumradikale auf und diese erhalten eine hohe Lateralbeweglichkeit auf der Substratoberfläche. Es entsteht eine polykristalline Siliziumschicht mit nicht zu kleiner Kristallitgröße. Durch Rekristallisation kann eine weitere Kornvergrößerung erzielt werden. Restliche Korngrenzeneinflüsse können außerdem durch Methoden wie die Passivierung mit Wasserstoff verringert werden.

Figur 4: Durch Behandlung im Ultraschallbad in einem die Paste (3) lösenden oder entfernenden Lösungsmittel, zum Beispiel Azeton, Alkohol wird dann das Streifenmuster 3 entfernt, wobei durch die bekannte Abhebetechnik (lift-off-Technik) die über diesen Pastenlinien 3 liegenden Bereiche der polykristallinen Siliziumschicht 4 mit abgehoben werden und so eine selektive Trennung der Siliziumschicht 4 (Dickschicht) erfolgt, ohne daß dabei mechanische Trennverfahren erforderlich sind. Es entstehen Trenngräben 5, die bis auf das Glassubstrat 1 durchgehen.

Figur 5: Auf die mit den Trenngräben 5 versehene Anordnung (1, 2, 4) wird nun ganzflächig eine aus transparentem Material, zum Beispiel aus dotiertem Zink- oder Zinnoxid bestehende Schicht aufgebracht und in bekannter Weise durch ein Siebdruckverfahren so strukturiert, daß die Frontelektroden 6 entstehen. Dabei wird der Trenngraben (5) im Bereich des Glassubstrats 1 mit Material mitaufgefüllt.

Aus Figur 6 ist die entstehende Serienverschaltung im Detail ersichtlich. Es gelten die gleichen Bezugszeichen wie in Figur 5. Im Prinzip wird jeweils die Kante der oberen transparenten Elektrode (6) einer Streifenzelle mit der Kante der unteren Elektrode (2) der benachbarten Streifenzelle verbunden, in dem die Siebdruckmasken für die drei Druckvorgänge (Metallelektrode, Streifenmuster aus Paste, transparente Elektrode) etwas gegeneinander verschoben werden. Alternativ kann die Struktur der Elektroden auch mit abhebbarem Material im Siebdruckverfahren erzeugt werden.

Die Herstellung der strukturierten polykristallinen Siliziumzelle kann, wie schon ausgeführt, in zwei verschiedenen Ablauffolgen durchgeführt werden, je nachdem, ob die metallische oder die transparente Elektrode zuerst auf dem Substrat abgeschieden wird. Sie umfaßt in beiden Fällen fünf Teilprozesse, die alle einen hohen Durchsatz bei geringem Investment erlauben, gut automatisierbar und damit kostengünstig sind.

Der Vorteil des Verfahrens liegt auch darin, daß unstrukturierte glatte und damit kostengünstige Glassubstrate verwendet werden können.

Figur 7 zeigt den schon erläuterten Aufbau und die Funktion von Tandemzellen mit vier Kontakten. Solche Tandemzellen sind bevorzugt durch das erfindungsgemäße Verfahren realisierbar. Der Pfeil mit dem Bezugszeichen 7 soll die kurzwellige Lichteinstrahlung, der Pfeil mit dem Bezugszeichen 8 die langwellige Lichteinstrahlung darstellen.

Figur 8 zeigt die zu einer Tandemzelle gemäß der Erfindung erforderlichen Bauteile vor der Montage, wobei mit dem Bezugszeichen I die a-Si:H-Zelle (Dünnschichtzelle), mit II die polykristalline Siliziumzelle (Dickschichtzelle), nach dem Verfahren nach der Lehre der Erfindung hergestellt, und mit III der optische Koppler bezeichnet sind. Der Zusammenbau erfolgt durch einen einfachen Laminierprozeß.

## Ansprüche

1. Verfahren zur integrierten Serienverschaltung einer Vielzahl von auf einem isolierenden transparenten Substrat angeordneten Dickschichtsolarzellen, **dadurch gekennzeichnet, daß**

a) ein Streifenmuster (3) vor der Abscheidung der Dickschicht (4) als Paste im Siebdruckverfahren auf die strukturierte Grundelektrode (2) so aufgebracht wird, daß es den in Richtung zur benachbarten, für die Verschaltung vorgesehenen Zelle liegenden Rand (12) bedeckt,

b) dann die Dickschicht (4) ganzflächig abgeschieden wird,

c) das Streifenmuster (3) durch Abhebetechnik entfernt wird, wobei die selektive Trennung der Dickschicht (4) erfolgt und

d) die Deckelektrode (6) ganzflächig aufgebracht und strukturiert wird.

2. Verfahren nach Anspruch 1, **dadurch gekennzeichnet,** daß eine Dickschicht (4) aus polykristallinem Silizium verwendet wird.

3. Verfahren nach Anspruch 1 oder 2, **dadurch gekennzeichnet,** daß eine Siebdruckpaste verwendet wird, welche poröses oder relativ grobkörniges Füllmaterial enthält.

4. Verfahren nach einem der Ansprüche 1 bis 3, **dadurch gekennzeichnet,** daß sowohl die Grundelektrode (2) als auch die Deckelektrode (6) durch Siebdruckverfahren strukturiert werden.

5. Verfahren nach einem der Ansprüche 1 bis 4, **dadurch gekennzeichnet,** daß als Grundelektrode (2) eine metallische Elektrode und als Deckelektrode (6) eine transparente Elektrode verwendet wird.

6. Verwendung des Verfahrens nach einem der Ansprüche 1 bis 5 bei der Herstellung von Tandemsolarzellen (I, II, III), bestehend jeweils mindestens aus einer Solarzelle (I) auf der Basis einer amorphen hydrogenisierten Siliziumschicht (a-Si:H) als aktive Schicht und einer Solarzelle (II) auf der Basis von polykristallinem Silizium als aktive Schicht und einem laminierten optischen Koppler (III), wobei die, zwei transparente Elektroden aufweisende a-Si:H-Zelle (I) als Frontzelle (Lichteinfallseite) geschaltet ist.

FIG 1

FIG 2

FIG 3

FIG 4

FIG 5

FIG 6

# FIG 7

# FIG 8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PROCEEDINGS OF THE SEVENTH E.C. PHOTOVOLTAIC SOLAR ENERGY CONFERENCE, Sevilla, 27.-31. Oktober 1986, Seiten 494-503, D. Reidel Publishing Co., Dordrecht, NL; W. JÜRGENS et al.: "Economical patterning of series connected a-silicon modules" * Seiten 496,501,503 * | 1,3,4 | H 01 L 27/14 H 01 L 25/08 |
| A | US-A-4 313 022 (J.F. JORDAN et al.) * Spalte 3, Zeile 50 - Spalte 7, Zeile 17; Figuren 1-3 * | 1 | |
| A | US-A-4 243 432 (J.F. JORDAN et al.) * Spalte 5, Zeile 35 - Spalte 10, Zeile 6; Figuren 1-8 * | 1 | |
| D,A | EP-A-0 232 749 (SIEMENS AG) * Insgesamt * | 1 | |
| A | PATENT ABSTRACTS OF JAPAN, Band 9, Nr. 95 (E-310)[1818], 24. April 1985, Seite 22 E 310; & JP-A-59 220 977 (SANYO DENKI K.K.) 12-12-1984 | | RECHERCHIERTE SACHGEBIETE (Int. Cl.4) H 01 L |
| A | THE CONFERENCE RECORD OF THE NINETEENTH IEEE PHOTOVOLTAIC SPECIALISTS CONFERENCE, New Orleans, Louisana, 4.-8. Mai 1987, Seiten 13-18, IEEE, New York, US; K. MITCHELL et al.: "High efficiency thin film tandem PV modules" * Insgesamt * | 1,6 | |

Der vorliegende Recherchenbericht wurde für alle Patentansprüche erstellt

| Recherchenort | Abschlußdatum der Recherche | Prüfer |
|---|---|---|
| DEN HAAG | 24-05-1989 | VISENTIN A. |

EPO FORM 1503 03.82 (P0403)